# EUROPÄISCHE PATENTSCHRIFT

(11) **EP 2 272 919 B1**
(45) Veröffentlichungstag und Bekanntmachung des Hinweises auf die Patenterteilung: **06.06.2012**
(21) Anmeldenummer: 09164931.9
(22) Anmeldetag: 08.07.2009
(51) Int. Cl.: C09B 45/14, C09D 11/00, G03F 7/00, G02B 5/22

(54) **Verfahren zur Herstellung von Pigmenten**
Method for manufacturing pigments
Procédé destiné à la fabrication de pigments

(43) Veröffentlichungstag der Anmeldung: 12.01.2011
(73) Patentinhaber: LANXESS Deutschland GmbH, 51369 Leverkusen (DE)
(72) Erfinder: Feldhues, Ulrich, Dr., 51465 Bergisch Gladbach (DE); Linke, Frank, 51069 Köln (DE)

(56) Entgegenhaltungen:
- EP-A- 0 994 162
- EP-A- 0 994 164
- EP-A- 1 086 992
- EP-A- 1 591 489
- EP-A- 1 777 266
- EP-A- 1 777 267
- EP-A- 1 777 268
- EP-A- 1 887 045
- DE-A1- 10 328 999

## Beschreibung

Die Erfindung betrifft ein Verfahren zur Herstellung von Melamin-eingelagerten Pigmenten.

Es ist bekannt, dass es bei der Herstellung von Azo-Barbitursäure Ni-Komplexen, die Melamin eingelagert enthalten sowie deren Hydrate, zu starken Schwankungen der Produkteigenschaften kommen kann. Insbesondere unter Produktionsbedingungen im industriellen Maßstab, besonders im Batch-Verfahren unterliegen bestimmte Parameter des erhaltenen Materials, wie z.B. die spezifische Oberfläche nach BET, mehr oder weniger starken Schwankungen. Dies ist natürlich nachteilig, da die Abnehmer der genannten Produkte eine konstante Produktqualität wünschen.

Eine gewisse Vereinheitlichung der Produktqualität (Reproduzierbarkeit) ist möglich durch einen Temperschritt, wie er beispielsweise in der EP-A1-0994162 oder der DE 10328999 A1 beschrieben ist. Das bedeutet natürlich insbesondere im industriellen Maßstab einen zusätzlichen zeitaufwändigen Schritt und damit eine Erhöhung der Fertigungskosten.

EP-A 1 612 246 beschreibt ebenfalls große Qualitätsschwankungen in der Batch-Produktion des Azo-Barbitursäure Ni-Komplexes nach dem Stand der Technik und schlägt vor, diesen Nachteil durch bestimmte Zusätze in der Synthese zu vermeiden. Das erfordert allerdings einen zusätzlichen logistischen Aufwand und hat Einfluss auf die Produktzusammensetzung, da diese Zusätze das Endprodukt verunreinigen können.

In der EP-A-1987045 wird ein Verfahren beschrieben, in dem eine Mischung aus der aus EP-A-1086992 bekannten Mono- und Di-Kationkomplexen der Azobarbitursäure mit einer Nickelverbindung und Melamin umgesetzt wird. Die Reproduzierbarkeit dieses Verfahrens ist bereits verbessert. Die nach diesem Verfahren erhaltenen Produkte zeigen aber immer noch Defizite in der Qualität, insbesondere bezüglich Partikelgröße, Partikelgrößenverteilung und der Transparenz.

Die EP -A- 1 777 267 und EP -A- 1 777 266 beschreiben ebenfalls Herstellungsverfahren für Azobarbitursäure-Ni-Komplexe, die in Farbfiltern für Flüssigkristallanzeigen Verwendung finden und gute Qualitäten besitzen.

Überraschenderweise wurde nun gefunden, dass man die Qualität von dem Azo-Barbitursäure Ni-Komplex, der Melamin eingelagert enthält, deutlich verbessern kann, wenn man eine Mischung aus dem Mono-Kationkomplex und der freien Azobarbitursäure, insbesondere eine Mischung aus dem Mono-Kaliumkomplex der Azobarbitursäure und der freien Azobarbitursäure mit Melamin und mit einer Nickelverbindung umsetzt. Die Verbindung der Formel (I), die Melamin eingelagert enthält, lässt sich nach dem erfindungsgemäßen Verfahren auch großtechnisch reproduzierbar mit ansteuerbarer Oberfläche, sehr hoher Farbstärke, sehr enger Partikelgrößenverteilung und sehr hoher Transparenz herstellen. Das ist besonders vorteilhaft für die Verwendung so hergestellter Pigmente für Farbfilter für Flüssigkristallanzeigen.

Die Erfindung betrifft daher ein Verfahren zur Herstellung von Pigmenten der Formel (I) 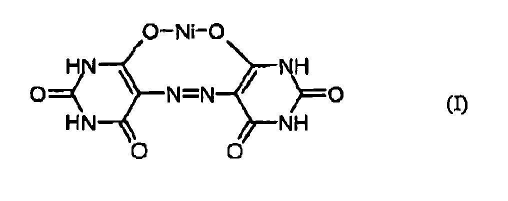 oder tautomerer Strukturen sowie ihre Hydrate davon, die Melamin oder Melaminderivate eingelagert enthalten, das dadurch gekennzeichnet ist, dass man das Azobarbitursäure-mono-Salz der Formel (II) mit einer Nickelverbindung und Melamin oder einem Melaminderivat in Gegenwart der freien Azobarbitursäure der Formel (III) umsetzt, 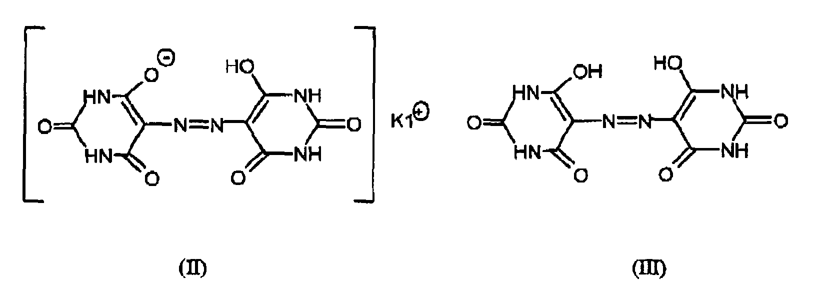 wobei das Kation K1^{⊕} für beliebige einwertige oder für den Anteil eines beliebigen mehrwertigen Kations steht, der einer positiven Ladung von eins entspricht, ausgenommen H⁻.

Als Melamin oder Melaminderivate sind insbesondere solche der Formel (IV) bevorzugt, 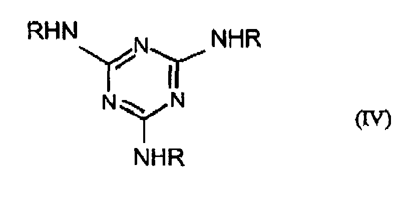 worin
- R: für Wasserstoff oder C₁-C₄-Alkyl, das gegebenenfalls mit OH-Gruppen substituiert ist, steht,
ganz besonders bevorzugt, worin
- R: für Wasserstoff steht.

Die Verbindung (I) kann neben Melamin auch ggf. weitere Verbindungen eingelagert enthalten, wie sie beispielsweise in der EP 0994162 (dort Seite 5, Zeile 40 bis Seite 7, Zeile 58) beschrieben sind. Vorzugsweise enthält die Verbindung (I) 1,5 bis 2,2 Einheiten Melamin oder Melaminderivat, insbesondere 1,9 bis 2,1 eingelagert.

Besonders bevorzugt steht das Kation K1^{⊕} in der Formel (II) für ein Alkalikation, insbesondere Li-Na- oder K-Kation, ½ Erdalkalikation, insbesondere ½ Mg, ½ Ca-Kation, 1/3 Al-Kation bzw. für gegebenenfalls mit beliebigen Resten substituiertes Ammonium-Kation, insbesondere für unsubstituiertes Ammoniumkation. Besonders bevorzugt steht K1^{⊕} für K⁺.

Bevorzugte Mono-Salze der Formel (II) sind Monohydrate.

Bevorzugt erzeugt man den Anteil der Formel (III) ausgehend von dem Mono-Salz (II) durch Zugabe einer sauren Verbindung, insbesondere durch Zugabe einer organischen oder anorganischen Säure oder saurer Salze, beispielsweise in Form einer Lösung, direkt aus dem Monokation-Komplex der Azobarbitursäure. Besonders bevorzugt erfolgt sie durch Zugabe von Salzsäure, Schwefelsäure oder Phosphorsäure, insbesondere in Form einer Lösung. Ganz besonders bevorzugt erzeugt man die Mischung durch Zugabe einer verdünnten wässrigen Salzsäurelösung aus dem Mono-Salz (II).

Bevorzugt ist das erfindungsgemäße Verfahren, bei dem bezogen auf die Summe der Formeln II und III, der Anteil der freien Azobarbitursäure der Formel III 5 - 80 Gew.-%, insbesondere 10 - 50 Gew.-%, ganz besonders bevorzugt 10 - 30 Gew.-% beträgt.

Als Nickelverbindungen kommen insbesondere Nickelformiat, Nickelnitrat, Nickelsulfat, Nickelchlorid und/oder Nickelacetat in Frage, besonders bevorzugt ist Nickelchlorid.

Bevorzugt wird die Nickelverbindung in einem molaren Verhältnis zur Summe der beiden Verbindungen der Formeln (II) und (III) 95% bis 120%, insbesondere von 100% bis 110% eingesetzt.

Vorzugsweise erfolgt das erfindungsgsmäße Verfahren bei einer Temperatur von 60 bis 100°C, insbesondere 70 - 90°C.

Bevorzugt erfolgt die erfindungsgemäße Umsetzung in einem Lösungsmittel, wobei insbesondere ein wasserhaltiges Lösungsmittelsystem verwendet wird. Als weitere Lösungsmittelbestandteile kommen organische Lösungsmittel in Frage. Bevorzugt dabei sind C₁ - C₄-Alkohole.

Besonders bevorzugt ist ein wässriges Lösungsmittel, insbesondere mit einem Anteil von Wasser von mehr als 50 Gew.-%, vorzugsweise von 80 - 100 Gew.-%. Ganz besonders bevorzugt erfolgt das erfindungsgemäße Verfahren in einem wässrigen Lösungsmittelsystem ohne Zusatz organischer Lösungsmittel.

In einer bevorzugten Ausführungsform des erfindungsgemäßen Verfahrens wird zu den Verbindungen der Formel (II) und (III) zuerst Melamin oder das Melaminderivat gegeben und danach die Nickelverbindung.

Vorzugsweise ist der pH bei der Reaktion mit der Nickelverbindung und mit Melamin kleiner pH 7, bevorzugt kleiner pH 3, insbesondere bei pH 1 bis 2.

Vorzugsweise wird die Reaktion zu Verbindung (I) nach der Zugabe der Nickelverbindung durch ein- bis fünfstündiges Nachrühren vervollständigt, insbesondere bei Temperaturen von 60 - 100°C.

Selbstverständlich kann man die nach dem exfindungsgemäßen Verfahren erhaltenen Pigmente durch einen Temperschritt, wie er beispielsweise in der EP A1-0994162 oder der DE 10328999 A1 beschrieben wird, nachbehandeln. Diese Nachbehandlung kann aber vorteilhaft auch ganz entfallen.

Die bei der Herstellung vorzugsweise erhaltene Suspension wird vorzugsweise filtriert und der so erhaltene Presskuchen kann gegebenenfalls nach Waschen mit Wasser getrocknet werden.

Dabei kommen einerseits übliche Trocknungsverfahren wie die Schaufeltrocknung usw. in Frage. Mit derartigen Trocknungsverfahren und anschließender Mahlung des Pigments auf übliche Weise werden pulverförmige Pigmente erhalten.

Bevorzugt wird der Presskuchen als wässrige Slurry sprühgetrocknet. Der zu versprühende Slurry besitzt vorzugsweise einen Feststoffanteil von 10 bis 40 Gew.-%, insbesondere 15 bis 30 Gew.-%.

Die getrockneten Pigmente liegen abhängig von den Trocknungsbedingungen vorzugsweise als Hydrate vor.

Bevorzugte nach dem erfindungsgemäßen Verfahren hergestellte Pigmente besitzen eine BET-Oberfläche von > 100 m²/g, vorzugsweise von 130 bis 210 m²/g, insbesondere von 150 bis 190 m²/g, die nach DIN 66131 ermittelt wurden.

Die nach dem erfindungsgemäßen Verfahren hergestellten Pigmente eignen sich zur Herstellung von Pigmentpräparationen, worin wenigstens ein erfindungsgemäß hergestelltes Pigment und wenigstens ein Dispergiermittel vermischt werden. Diese Pigmentpräparationen dienen vorzugsweise der Einarbeitung in wässrige Systeme.

Bezüglich geeigneter Dispergiermittel kann auf den Stand der Technik verwiesen werden, insbesondere die EP-A1-0994164, Seite 8, Zeile 56 bis Seite 11, Zeile 23, deren Offenbarung zum Gegenstand dieser Anmeldung gehören.

Die nach dem erfindungsgemäßen Verfahren hergestellten Pigmente eignen sich zur Herstellung eines Photolacks der wenigstens ein photohärtbares Monomer und wenigstens einen Photoinitiator und wenigstens ein nach dem erfindungsgemäßen Verfahren hergestelltes Pigment enthält. Die nach dem erfindungsgemäßen Verfahren hergestellten Pigmente eignen sich weiterhin zur Herstellung von Farbfiltern und daraus hergestellten Flüssigkristallanzeigen., Bei der Herstellung der Farbfilter für Flüssigkristallanzeigen wird das nach dem erfindungsgemäßen Verfahren hergestellte Pigment, vorzugsweise in einem organischen Lösungsmittel gegebenenfalls unter Zusatz eines Bindemittelharzes und/oder Dispergiermittels gemahlen, anschließend unter Zusatz von photohärtbaren Monomeren, Photoreaktionsstarter und ggf. weiterem Bindemittel und/oder Lösungsmittel zu einem Photolack verarbeitet, der im Anschluss daran mittels geeigneter Beschichtungsverfahren wie z.B. Roller-, Spray-, Spin-, Dip- oder Air-Knife-Coating auf ein geeignetes Substrat, im Allgemeinen eine Glasplatte aufgetragen wird, mittels Photomaske belichtet und anschließend gehärtet und zum fertigen farbigen Filter entwickelt wird.

Die nach dem erfindungsgemäßen Verfahren hergestellten Pigmente eignen sich weiterhin bevorzugt als Farbfilter in Flüssigkristallanzeigen.

Die nach dem erfindungsgemäßen Verfahren hergestellte Verbindung (I), die Melamin eingelagert enthält, oder Pigmentpräparationen davon eignen sich überdies hervorragend für alle Pigmentanwendungszwecke.

Zum Beispiel eignet sie sich zum Pigmentieren von Lacken aller Art, für die Herstellung von Druckfarben, Leimfarben oder Binderfarben, für die Massefärbung von synthetischen, halbsynthetischen oder natürlichen makromolekularen Stoffen, wie z.B. Polyvinylchlorid, Polystyrol, Polyamid, Polyethylen oder Polypropylen. Sie können auch für die Spinnfärbung von natürlichen, regenerierten oder künstlichen Fasern, wie z.B. Cellulose-, Polyester-, Polycarbonat-, Polyacrylnitril- oder Polyamidfasern, sowie zum Bedrucken von Textilien und Papier verwendet werden. Aus diesen Pigmenten können feinteilige, stabile, wässrige Pigmentierungen von Dispersions- und Anstrichfarben, die für die Papierfärbung, für den Pigmentdruck von Textilien, für den Laminatdruck oder für die Spinnfärbung von Viskose brauchbar sind, durch Mahlen oder Kneten in Gegenwart von nichtionogenen, anionischen oder kationischen Tensiden hergestellt werden. Die nach dem erfindungsgemäßen Verfahren hergestellten Pigmente eignen sich hervorragend für Ink Jet Anwendungen und für Farbfilter für Flüssigkristallanzeigen.

### Beispiele

### a) Synthese

### Monokaliumsalz

Ausgangsmaterial für das erfindungsgemäße Verfahren war das Beispiel 1 der EP-A 1 086 992, d.h. die α-Modifikation Azobarbitursäure Monokaliumsalz x 1 H₂O, das nachfolgend beschrieben wird.

In 810 g dest. Wasser wurden 136 g Aminoguanidinbicarbonat eingetragen und mit 280 g Salzsäure (30 %ig) gelöst. Danach wurde mit 780 g Eis auf ca. -10°C abgekühlt und anschließend mit 232 g einer 37 %igen Kaliumnitritlösung in Wasser bis ca. 15°C versetzt. Danach wurde bei ca. 15°C 15 min nachgerührt und anschließend mit 2,0 g Amidoschwefelsäure versetzt. Danach wurden 269 g Barbitursäure eingetragen, anschließend wurde auf 55°C erwärmt und 2 h nachgerührt. Anschließend wurde mit wässriger Kalilauge auf pH 2,5 eingestellt und 30 min nachgerührt. Danach wurde mit wässriger Kalilauge auf pH 4,8 eingestellt und 30 min nachgerührt. Anschließend wurde der Ansatz auf 80°C erwärmt und 3 h bei pH 4,8 nachgerührt. Danach wurde auf einer Saugnutsche isoliert und elektrolytfrei gewaschen.

### Nicht-erfindungsgemäßes Synthese-Vergleichs-Beispiel N

425 g wasserfeuchte Paste der oben beschriebenen a-Modifikation Azobarbitursäure Monokaliumsalz x 1 H₂O mit einem Trockengehalt von 40 %, entsprechend 170 g trocken (0,5mol), wurden in 5000 ml destilliertem Wasser mit einem Laborrührer verrührt und auf 95°C erwärmt. 1060 g wässrige 6,5 %ige Nickelchloridlösung wurden innerhalb 30 min zugesetzt. Danach wurden 126 g Melamin (1mol) zugegeben und 1,5 h bei 95°C nachgerührt. Danach wurde mit Kalilauge auf pH 5,5 gestellt. Anschließend wurde auf einer Saugnutsche isoliert, elektrolytfrei gewaschen, bei 80°C im Vakuumtrockenschrank getrocknet und gemahlen.

Die spezifische Oberfläche wurde nach DIN 66131 ermittelt: Bestimmung der spezifischen Oberfläche von Feststoffen durch Gasadsorption nach Brunauer, Emmett und Teller (B.E.T.).

Das Produkt hatte eine BET-Oberfläche von 83 m²/g, das Produkt zeigte im Elektronenmikroskop sehr uneinheitliche, teils plättchenförmige, teils ausgeprägt nadelförmige Partikel.

Wiederholungssynthesen zeigten erhebliche Variation (57 m²/g - 92 m²/g).

### Erfindungsgemäßes Synthese-Beispiel 1

425 g wasserfeuchte Paste der oben hergestellten α-Modifikation Azobarbitursäure Monokaliumsalz x 1 H₂O mit einem Trockengehalt von 40 %, entsprechend 170 g trocken (0,5mol), wurden in 5000 ml destilliertem Wasser mit einem Laborrührer verrührt und auf 80°C erwärmt.

12 g 30 %ige Salzsäure wurden zugetropft (0,1 mol; 20 % bezogen auf eingesetztes Azobarbitursäure-Monokaliumsalz) und 30min nachgerührt. Dabei entstand eine Mischung im Molverhältnis 80 Teile Monokaliumsalz und 20 Teile freie Azobarbitursäure. 126 g Melamin (1 mol) wurden zugegeben. 1060 g wässrige 6,5 %ige Nickelchloridlösung wurden innerhalb 30 min zugesetzt und danach wurde 3 h bei 80°C nachgerührt. Danach wurde mit Kalilauge auf pH 5,5 gestellt. Anschließend wurde auf einer Saugnutsche isoliert, elektrolytfrei gewaschen, bei 80°C im Vakuumtrockenschrank getrocknet und gemahlen.

Die spezifische Oberfläche wurde nach DIN 66131 ermittelt: Bestimmung der spezifischen Oberfläche von Feststoffen durch Gasadsorption nach Brunauer, Emmett und Teller (B.E.T.).

Das Produkt hatte eine BET-Oberfläche von 170 m²/g. Das Produkt zeigte im Elektronenmikroskop sehr einheitliche, kleine, fast plättchenförmige Partikel.

Wiederholungssynthesen zeigten geringe Variation (161 m²/g - 178 m²/g).

### Erfindungsgemäßes Synthese-Beispiel 2

Umsetzung wie im Beispiel 1, es wurden aber 6 g 30%ige Salzsäure zugetropft (0,05mol; 10% bezogen auf eingesetztes Azobarbitursäure-Monokaliumsalz). Dabei entstand eine Mischung im Molverhältnis 90 Teile Monokaliumsalz und 10 Teile freie Azobarbitursäure.

Das Produkt hatte eine BET-Oberfläche von 166 m²/g. Das Produkt zeigte im Elektronenmikroskop sehr einheitliche, kleine, fast plättchenförmige Partikel.

Wiederholungssynthesen zeigten geringe Variation (158 m²/g- 171 m²/g).

### Erfindungsgemäßes Synthese-Beispiel 3

Umsetzung wie im Beispiel 1, es wurden aber 18 g 30 %ige Salzsäure zugetropft (0,15 mol; 30 % bezogen auf eingesetztes Azobarbitursäure-Monokaliumsalz). Dabei entstand eine Mischung im Molverhältnis 70 Teile Monokaliumsalz und 30 Teile freie Azobarbitursäure.

Das Produkt hatte eine BET-Oberfläche von 178 m²/g. Das Produkt zeigte im Elektronenmikroskop sehr einheitliche, kleine, kurznadelige Partikel.

Wiederholungssynthesen zeigten geringe Variation (165 m²/g - 186 m²/g).

### Verwendungsbeispiele

Herstellung einer gelben Zubereitung und Verwendung zur Herstellung eines gelben Farbfilters

### Verwendungsbeispiel 1 (erfindungsgemäß):

### Einsatzpigment: Pigment aus dem erfindungsgemäßen Synthese-Beispiel 1

In einem Rührbehälter wurden 774 Gew.-Teile Methoxybutylacetat und 286 Gew.-Teile einer 21%igen Lösung eines alkalisch löslichen Copolymeren (Bindemittelharz) auf Basis von Benzylmethacrylat (70T) / 2-Hydroxyethylmethacrylat (15T) / Methacrylsäure (15T), Molgewicht ca. 25.000 g/mol, in Methoxypropylacetat homogen gemischt. Erhalten wurde eine "Zubereitung."

Anschließend wurden 100 Gew.Teile Pigment aus Beispiel 1, das zuvor bei 80°C auf eine Restfeuchte von weniger als 1 Gew% getrocknet wurde, homogen in die Zubereitung eingetragen.

Die Pigmentsuspension wurde in einer horizontalen, geschlossenen Perlmühle unter Einsatz von Yttrium-stabilisierten Zirkonoxid-Perlen (Durchmesser 0,6 bis 1,0 mm) gemahlen.

### Herstellung eines Photolacks

Zu 1000 Gew.-Teilen der so erhaltenen Zubereitung wurden 34,5 Gew.-Teile Trimethylolpropantriacrylat (monomerer Reaktivverdünner) und 13,8 Gew.Teile eines Photoreaktionsstarters auf Basis von Benzophenon und N,N'-Tetraethyl-4,4'-diaminobenzophenon im Verhältnis von 3/1 Gew.Teilen unter Rühren homogen eingetragen.

Man erhielt einen UV-strahlungshärtbaren Photolack, der auf einem transparenten Substrat aufgetragen und zum Farbfilter entwickelt wurde.

Hierzu wurde der Photolack mittels Spin-Coating auf ein 300 x 350 mm großes Stück gereinigtes Borosilikatglas (Corning® 7059, Owens Corning Corp.) beschichtet und bei 110°C 5 Minuten in einem Ofen unter Reinbedingungen zu einem ca. 1,5 - 2µm dicken Film getrocknet.

Anschließend wurde der Film nach Abkühlung mittels einer Negativmaske zur Erzielung des gewünschten Streifenbildmusters und einer Ultrahochdruck-Quecksilberdampflampe bei einer Dosis von 200 mJ / cm² UV-belichtet und dann mittels 0,06 %iger wässriger Kaliumhydroxidlösung bei Raumtemperatur entwickelt, mit vollentsalztem Wasser gereinigt und getrocknet. Anschließend erfolgte eine 30 minütige Nachhärtung bei 235°C in einem Ofen unter Reinbedingungen.

Der so erhaltene gelbe erfindungsgemäße Farbfilter 1 besaß gegenüber dem nicht-erfindungsgemäßen Farbfilter N, hergestellt gemäß dem Verwendungsbeispiel N eine sehr deutlich verbesserte spektrale Transparenz. Die Farbreinheit und Brillanz des Farbfilters 1 ist ausgezeichnet.

### Verwendungsbeispiel N (nicht erfindungsgemäß):

### Einsatzpigment: Pigment aus dem nicht-erfindungsgemäßen Synthese-Vergleichsbeispiel N

Analog dem Verwendungsbeispiel 1 wurden 100 Gew.Teile Pigment aus dem nicht-erfindungsgemäßen Vergleichsbeispiel N, das zuvor bei 80°C auf eine Restfeuchte von weniger als 1 Gew% getrocknet wurde, homogen in die Zubereitung aus Verwendungsbeispiel 1 eingetragen.

Die erhaltene Pigmentsuspension wurde in einer horizontalen, geschlossenen Perlmühle unter Einsatz von Yttrium-stabilisierten Zirkonoxid-Perlen analog dem Verwendungsbeispiel 1 gemahlen.

Die Herstellung des Photolacks erfolgte ebenfalls analog zum Verwendungsbeispiel 1.

### Verwendungsbeispiel 2 (erfindungsgemäß)

### Einsatzpigment: Pigment aus dem erfindungsgemäßen Synthese-Beispiel 2

Analog dem Verwendungsbeispiel 1 wurden 100 Gew.Teile Pigment aus dem Synthese-Beispiel 2, das zuvor bei 80°C auf eine Restfeuchte von weniger als 1 Gew% getrocknet wurde, homogen in die Zubereitung aus Verwendungsbeispiel 1 eingetragen.

Die erhaltene Pigmentsuspension wurde in einer horizontalen, geschlossenen Perlmühle unter Einsatz von Yttrium-stabilisierten Zirkonoxid-Perlen analog dem Verwendungsbeispiel 1 gemahlen.

Die Herstellung des Photolacks erfolgte ebenfalls analog zum Verwendungsbeispiel 1.
Der so erhaltene gelbe erfindungsgemäße Farbfilter 2 besaß gegenüber dem nicht-erfindungsgemäßen Farbfilter N, hergestellt gemäß dem Verwendungsbeispiel N eine sehr deutlich verbesserte spektrale Transparenz. Die Farbreinheit und Brillanz des Farbfilters 2 ist ausgezeichnet.

### Verwendungsbeispiel 3 (erfindungsgemäß)

### Einsatzpigment: Pigment aus dem erfindungsgemäßen Synthese-Beispiel 3

Analog dem Verwendungsbeispiel 1 wurden 100 Gew.Teile Pigment aus dem Synthese-Beispiel 3, das zuvor bei 80°C auf eine Restfeuchte von weniger als 1 Gew% getrocknet wurde, homogen in die Zubereitung aus Verwendungsbeispiel 1 eingetragen.

Die erhaltene Pigmentsuspension wurde in einer horizontalen, geschlossenen Perlmühle unter Einsatz von Yttrium-stabilisierten Zirkonoxid-Perlen analog dem Verwendungsbeispiel 1 gemahlen.

Die Herstellung des Photolacks erfolgte ebenfalls analog zum Verwendungsbeispiel 1.
Der so erhaltene gelbe erfindungsgemäße Farbfilter 3 besaß gegenüber dem nicht-erfindungsgemäßen Farbfilter N, hergestellt gemäß dem Verwendungsbeispiel N eine sehr deutlich verbesserte spektrale Transparenz. Die Farbreinheit und Brillanz des Farbfilters 3 ist ausgezeichnet.

## Patentansprüche

1. Verfahren zur Herstellung von Pigmenten der Formel (I) 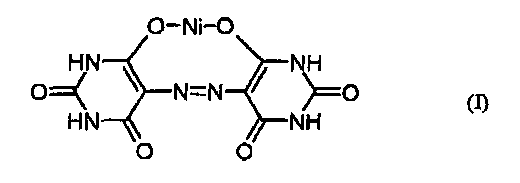 oder tautomerer Strukturen sowie ihre Hydrate davon, die Melamin oder Melaminderivate eingelagert enthalten, **dadurch gekennzeichnet, dass** man das Azobarbitursäure-mono-Salz der Formel (II) mit einer Nickelverbindung und Melamin oder einem Melaminderivat in Gegenwart der freien Azobarbitursäure der Formel (III) umsetzt, 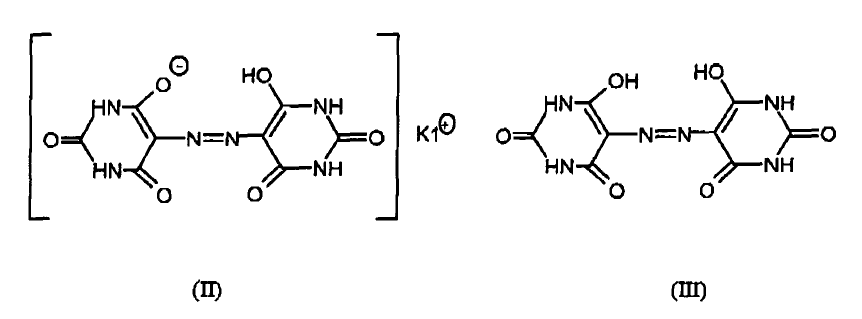 wobei das Kation K1^{⊕} für beliebige einwertige oder für den Anteil eines beliebigen mehrwertigen Kations steht, der einer positiven Ladung von eins entspricht, ausgenommen H⁺.

2. Verfahren gemäß Anspruch 1, **dadurch gekennzeichnet, dass** Kation K1^{⊕} in der Formel (II) für ein Alkalikation, insbesondere Li-, Na-, K-Kation, ½ Erdalkalikation, insbesondere ½ Mg-, ½ Ca-Kation, für 1/3 Al-Kation oder für gegebenenfalls substituiertes Ammonium-Kation, insbesondere für unsubstituiertes Ammoniumkation steht.

3. Verfahren gemäß Anspruch 1, **dadurch gekennzeichnet, dass** Kation K1^{⊕} für K^{⊕} steht.

4. Verfahren gemäß Anspruch 1, **dadurch gekennzeichnet, dass** bezogen auf die Summe der beiden Verbindungen der Formeln (II) und (III) der Anteil der freien Azobarbitursäure der Formel (III) 5 - 80 Gew.-%, insbesondere 10 - 50 Gew.-%, ganz besonders bevorzugt 10 - 30 Gew.-% beträgt.

5. Verfahren gemäß Anspruch 1, **dadurch gekennzeichnet, dass** der Anteil der Formel (III) ausgehend vom Monosalz II durch Zugabe einer sauren Verbindung, insbesondere durch Zugabe einer organischen oder anorganischen Säure erzeugt wird.

6. Verfahren gemäß Anspruch 1, **dadurch gekennzeichnet, dass** zu den Verbindungen der Formeln (II) und (III) zuerst Melamin oder ein Melaminderivat und dann die Nickelverbindung zugesetzt wird.

7. Verfahren gemäß Anspruch 1, **dadurch gekennzeichnet, dass** die hergestellten Pigmente eine BET-Oberfläche, ermittelt nach DIN 66131 von größer 100 m²/g, insbesondere von 130 bis 210 m²/g besitzen.

8. Verfahren gemäß Anspruch 1, **dadurch gekennzeichnet, dass** man die Verbindungen der Formeln (II) und (III) bei pH < 7 mit Melamin und einem Nickelsalz umsetzt.

## Claims

1. Process for preparing pigments of the formula (I) 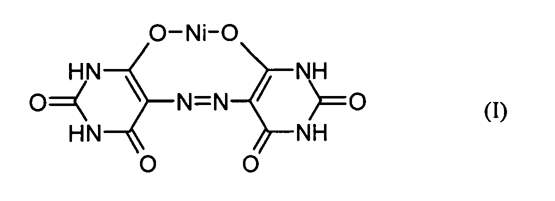 or tautomeric structures thereof and their hydrates, containing melamine or melamine derivatives as guest(s), **characterized in that** the azobarbituric mono-salt of the formula (II) is reacted with a nickel compound and melamine or a melamine derivative in the presence of the free azobarbituric acid of the formula (III), 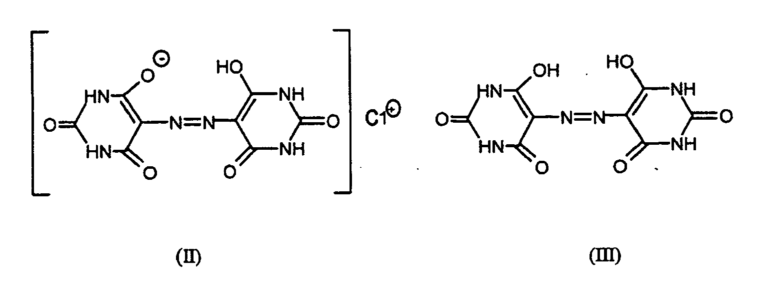 where the cation C1^{⊕} is any desired univalent cation or the fraction of any desired multivalent cation that corresponds to a positive charge of one, except for H⁺.

2. Process according to Claim 1, **characterized in that** the cation C1^{⊕} in the formula (II) is an alkali metal cation, especially Li, Na, K cation, ½ alkaline earth metal cation, especially ½ Mg, ½ Ca cation, is 1/3 Al cation or is unsubstituted or substituted ammonium cation, especially unsubstituted ammonium cation.

3. Process according to Claim 1, **characterized in that** the cation C1^{⊕} is K^{⊕}.

4. Process according to Claim 1, **characterized in that**, based on the sum of both compounds of the formulae (II) and (III), the fraction of the free azobarbituric acid of the formula (III) is 5 - 80% by weight, in particular 10 - 50% by weight, very preferably 10 - 30% by weight.

5. Process according to Claim 1, **characterized in that** the fraction of the formula (III) is produced starting from the mono-salt II by adding an acidic compound, in particular by adding an organic or inorganic acid.

6. Process according to Claim 1, **characterized in that** first melamine or a melamine derivative, and then the nickel compound are added to the compounds of the formulae (II) and (III).

7. Process according to Claim 1, **characterized in that** the pigments prepared possess a BET surface area, determined in accordance with DIN 66131, of greater than 100 m²/g, in particular from 130 to 210 m²/g.

8. Process according to Claim 1, **characterized in that** the compounds of the formulae (II) and (III) are reacted at pH < 7 with melamine and a nickel salt.

## Revendications

1. Procédé pour la fabrication de pigments de formule (I) 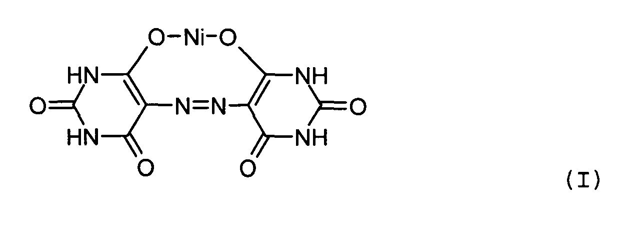 ou de leurs structures tautomères ainsi que de leurs hydrates, qui contiennent incorporés de la mélamine ou des dérivés de mélamine, **caractérisé en ce qu'**on fait réagir le monosel d'acide azobarbiturique de formule (II) avec un composé de nickel et de la mélamine ou un dérivé de mélamine en présence de l'acide azobarbiturique libre de formule (III), 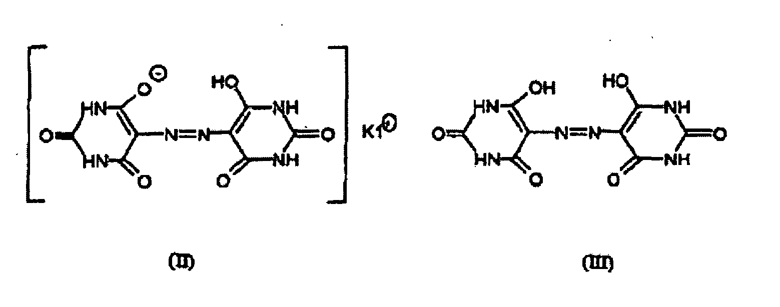 le cation K1^{⊕} représentant des cations monovalents quelconques ou la partie d'un cation plurivalent quelconque, qui correspond à une charge positive égale à un, à l'exception de H⁺.

2. Procédé selon la revendication 1, **caractérisé en ce que** le cation K1^{⊕} dans la formule (II) représente un cation alcalin, en particulier le cation Li, Na, K, un ½ cation alcalino-terreux, en particulier ½ cation Mg, ½ cation Ca, 1/3 cation Al ou un cation ammonium éventuellement substitué, en particulier le cation ammonium non substitué.

3. Procédé selon la revendication 1, **caractérisé en ce que** le cation K1^{⊕} représente K^{⊕}.

4. Procédé selon la revendication 1, **caractérisé en ce que**, par rapport à la somme des deux composés de formules (II) et (III), la proportion de l'acide azobarbiturique libre de formule (III) vaut 5 - 80 % en poids, en particulier 10 - 50 % en poids, de façon tout particulièrement préférée 10 - 30 % en poids.

5. Procédé selon la revendication 1, **caractérisé en ce que** le constituant de formule (III) est produit à partir du monosel II par addition d'un composé acide, en particulier par addition d'un acide organique ou inorganique.

6. Procédé selon la revendication 1, **caractérisé en ce qu'**on ajoute aux composés de formules (II) et (III) d'abord de la mélamine ou un dérivé de mélamine et ensuite le composé de nickel.

7. Procédé selon la revendication 1, **caractérisé en ce que** les pigments produits ont une surface BET, déterminée selon DIN 66131, de plus de 100 m²/g, en particulier de 130 à 210 m²/g.

8. Procédé selon la revendication 1, **caractérisé en ce qu'**on fait réagir les composés de formule (II) et (III) avec de la mélamine et un sel de nickel à pH < 7.
